# FASCICULE DE BREVET EUROPEEN

(11) **EP 3 730 959 B1**
(45) Date de publication et mention de la délivrance du brevet: **09.02.2022**
(21) Numéro de dépôt: 20160154.9
(22) Date de dépôt: 28.02.2020
(51) Int. Cl.: G01R 33/24

(54) **MAGNÉTOMÈTRE ASSERVI EN CHAMP NUL AVEC FILTRAGE BASSE FRÉQUENCE DU CHAMP DE COMPENSATION**
MAGNETOMETER GESTEUERT BEI FELDSTÄRKE NULL MIT NIEDRIGFREQUENZFILTERUNG DES KOMPENSATIONSFELDS
SLAVE ZERO FIELD MAGNETOMETER WITH LOW-FREQUENCY FILTERING OF THE COMPENSATION FIELD

(30) Priorité: 12.03.2019 FR 1902495
(43) Date de publication de la demande: 28.10.2020
(73) Titulaire: Commissariat à l'énergie atomique et aux énergies alternatives, 75015 Paris (FR)
(72) Inventeur: LE PRADO, Matthieu, 38054 GRENOBLE Cedex 09 (FR); PALACIOS LALOY, Agustin, 38054 GRENOBLE Cedex 09 (FR)
(74) Mandataire: Brevalex

(56) Documents cités:
- FR-B1- 3 056 761
- MORALES S ET AL: "Magnetocardiography measurements with 4He vector optically pumped magnetometers at room temperature", PHYSICS IN MEDICINE AND BIOLOGY, INSTITUTE OF PHYSICS PUBLISHING, BRISTOL GB, vol. 62, no. 18, 21 août 2017 (2017-08-21) , pages 7267-7279, XP020319607, ISSN: 0031-9155, DOI: 10.1088/1361-6560/AA6459 [extrait le 2017-08-21]

## Description

### DOMAINE TECHNIQUE

Le domaine de l'invention est celui des magnétomètres à pompage optique asservis en champ nul. L'invention trouve notamment application pour l'imagerie magnétique du cerveau ou du cœur au moyen de magnétomètres déployés en un réseau.

### ÉTAT DE LA TECHNIQUE ANTÉRIEURE

Les magnétomètres à pompage optique utilisent des gaz atomiques confinés dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :
1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.
2) Ces états atomiques évoluent sous l'effet du champ magnétique, notamment sous l'effet Zeeman, qui correspond à des décalages des niveaux d'énergie en fonction du champ magnétique auquel les atomes sont soumis.
3) Les propriétés optiques du milieu atomique subissent alors des modifications qui dépendent de l'état des atomes. On peut ainsi par une mesure optique, par exemple par une mesure d'absorption optique, remonter au décalage Zeeman subi, et en déduire une mesure du champ magnétique dans lequel est plongée la cellule.

Selon les différentes configurations possibles des magnétomètres à pompage optique existants, on distingue une mesure du module, aussi appelée norme, du champ magnétique pour les magnétomètres scalaires, ou une détermination des différentes composantes du champ magnétique pour les magnétomètres vectoriels.

Pour réaliser une mesure vectorielle du champ magnétique avec une bande passante large, il existe deux configurations bien connues : la première dite «à effet Hanle » et la deuxième qui reçoit le nom de « magnétomètre à résonance paramétrique ». Ces configurations sont décrites notamment dans l'article de J. Dupont-Roc, "Détermination par des méthodes optiques des trois composantes d'un champ magnétique très faible," Revue de Physique Appliquée, vol. 5, no. 6, pp. 853-864, 1970. Elles fonctionnent à des valeurs de champ magnétique extérieur très faibles, induisant un décalage Zeeman plus faible que le taux de relaxation des sous-niveaux Zeeman de l'atome, ce qui pour le cas de l'hélium fixe une limite autour de 100 nano Tesla, soit 500 fois moins intense que le champ magnétique terrestre.

Lorsqu'un faible champ magnétique statique transverse est appliqué à la cellule et balayé autour de zéro, les atomes sont soumis à un mouvement de précession et le nombre de photons absorbés, provenant du laser de pompage optique, subit des variations résonantes (effet Hanle). Des résonances analogues, appelées résonances paramétriques sont observées lorsqu'un champ magnétique modulé en fréquence (dit champ radiofréquence) est appliqué. Dans ces conditions, le moment magnétique de chaque atome subit des oscillations résonantes aux fréquences multiples de celle du champ radiofréquence.

Le magnétomètre à résonance paramétrique permet de déduire les trois composantes du champ magnétique ambiant de manière indépendante ce qui rend possible la mesure vectorielle. Les deux composantes parallèles à l'axe d'application de deux champs radiofréquence sont ainsi obtenues en mesurant l'amplitude du signal de photo-détection à la fréquence d'oscillation du champ radiofréquence correspondant et en quadrature avec celle-ci. En effet, cette amplitude est directement proportionnelle au champ magnétique parallèle à l'axe du champ radiofréquence correspondant. Il est également possible d'obtenir la troisième composante du champ magnétique (perpendiculaire aux deux champs RF) car la première inter-harmonique des deux fréquences d'oscillation des champs radiofréquence est proportionnelle à l'amplitude de cette troisième composante. Toutefois les facteurs de proportionnalité pour la mesure de ce troisième axe sont fortement défavorables par rapport aux deux premiers. Ainsi, le bruit dont est assortie la mesure du champ selon ce troisième axe est typiquement trois à huit fois plus élevé que celui associés aux deux autres axes.

Dans ces deux configurations, il est avantageux de faire fonctionner le magnétomètre « en boucle fermée » en venant constamment soumettre l'élément sensible à un champ magnétique total nul. Ce fonctionnement dit avec asservissement en champ nul présente notamment l'avantage d'être moins sensible à la variation des paramètres impactant les propriétés du magnétomètre (puissance laser, densité de l'élément sensible...).

Le champ magnétique total nul est obtenu en générant des champs magnétiques de compensation par injection de courants dans des bobines appropriées qui entourent l'élément sensible. Ces champs de compensation viennent annuler chacune des composantes du champ magnétique ambiant au moyen d'une régulation en boucle fermée des courants injectés. La mesure des courants circulant dans les bobines permet de déduire les champs qu'il est nécessaire d'appliquer pour annuler les différentes composantes du champ ambiant, et donc de disposer de la valeur de ces différentes composantes du champ ambiant.

Dans le cadre d'un réseau de magnétomètres, les champs magnétiques de compensation générés par les bobines d'un magnétomètre sont également vus par les autres magnétomètres du réseau, les plus proches en particulier. Ils viennent perturber les mesures effectuées par les autres magnétomètres du réseau en apportant à la fois biais et bruit supplémentaires.

Une solution de compensation des biais ainsi induits a été proposée dans le brevet FR 3056761 B1. Si cette solution permet de corriger la justesse des mesures réalisées par les magnétomètres du réseau, elle ne permet pas de réduire le risque que l'excès de bruit induit par les champs de compensation entraîne des mesures erronées ou saturées.

### EXPOSÉ DE L'INVENTION

L'invention vise à réduire le bruit dont sont affectées les mesures réalisées par un magnétomètre appartenant à un réseau de magnétomètres, notamment le bruit induit par les champs de compensation générés par les autres magnétomètres du réseau. Elle propose à cet effet un magnétomètre selon la revendication indépendante 1 destiné à la mesure d'un champ magnétique ambiant présentant une plage fréquentielle d'intérêt, comprenant :
une source de pompage optique agencée pour émettre en direction d'une cellule remplie d'un gaz atomique un faisceau de lumière polarisé linéairement selon une direction de polarisation,
un circuit d'excitation de résonances paramétriques configuré de manière à induire dans la cellule un champ magnétique radiofréquence présentant deux composantes orthogonales à la direction de polarisation et oscillant chacune à sa propre fréquence d'oscillation,
un circuit de détection de résonances paramétriques configuré pour réaliser une détection synchrone à un inter-harmonique des fréquences d'oscillation d'un signal électrique délivré par un photodétecteur agencé pour recevoir le faisceau de lumière ayant traversé la cellule,
un circuit d'asservissement en champ nul configuré pour générer à partir de ladite détection synchrone un champ magnétique de compensation opposé à une composante du champ magnétique ambiant orientée selon la direction de polarisation.

Ledit circuit d'asservissement comprenant un filtre passe bas qui présente une fréquence de coupure sélectionnée pour atténuer le champ magnétique de compensation dans la plage fréquentielle d'intérêt ;
Certains aspects préférés mais non limitatifs de ce magnétomètre sont les suivants :
ledit circuit d'asservissement comprend un intégrateur configuré pour délivrer un signal de compensation, un générateur de courant apte à être piloté par le signal de compensation pour injecter un courant dans une bobine, le filtre passe-bas étant interposé entre l'intégrateur et la bobine ;
le filtre passe-bas est interposé entre l'intégrateur et le générateur de courant ; le filtre passe-bas est un filtre numérique, par exemple un filtre de Butterworth d'ordre 4.

### BRÈVE DESCRIPTION DES DESSINS

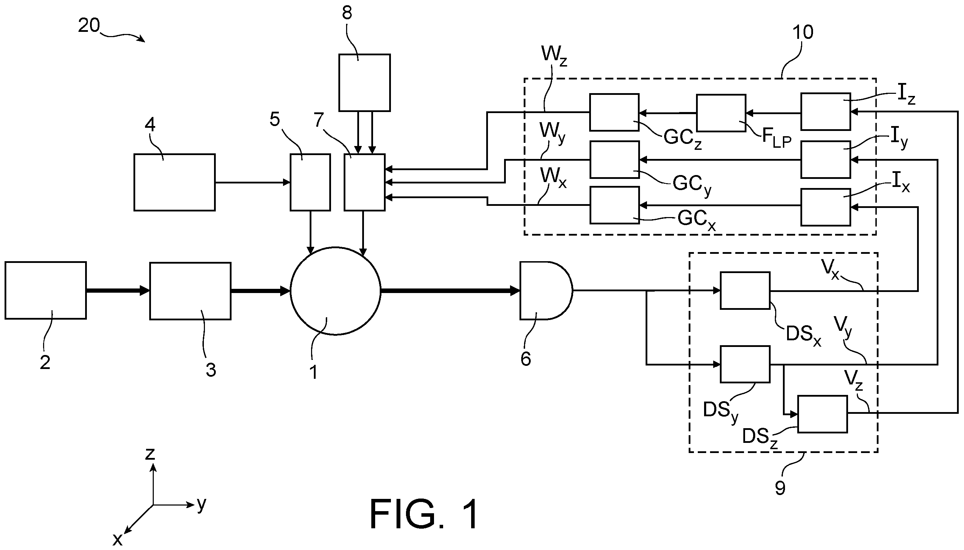

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence au dessin annexé sur lequel la figure 1 représente un schéma d'un magnétomètre conforme à l'invention.

### DESCRIPTION DÉTAILLÉE

En référence à la figure 1, l'invention porte sur un magnétomètre vectoriel à pompage optique 20 qui comprend une cellule 1 remplie d'un gaz atomique, par exemple de l'hélium-4 ou un gaz alcalin, soumis à un champ magnétique ambiant dont la projection sur trois axes de coordonnées rectangulaires x, y, z définit trois composantes. Le champ magnétique ambiant se décompose ainsi en trois composantes Bx, By et Bz chacune selon l'un des axes de mesure du magnétomètre x, y et z. Le champ ambiant présente une plage fréquentielle d'intérêt, par exemple comprise entre 1 et 200 Hz pour des applications de magnétocardiographie ou de magnétoencéphalographie (MEG).

La cellule est éclairée par une source de pompage optique 2, 3 agencée pour émettre en direction de la cellule 1 un faisceau de lumière, par exemple un faisceau laser, accordé à une longueur d'onde de pompage (ce faisceau est ainsi également désigné par faisceau de pompe) et polarisé linéairement. La longueur d'onde de pompage est calée sur une raie de transition atomique, par exemple sur la raie D₀ à 1083 nm dans le cas de l'hélium-4. Le faisceau de lumière peut être émis par une source laser 2 et être polarisé linéairement au moyen d'un polariseur rectiligne 3 intercalé entre la source laser 2 et la cellule 1 ou directement intégré à la source laser 2. Le faisceau de lumière se propage selon une direction de propagation confondue avec l'axe x, et est polarisé linéairement selon l'axe z.

Dans le cas où l'élément sensible est l'hélium-4, le magnétomètre 20 comporte par ailleurs un système de décharge haute fréquence (HF), comprenant un générateur HF 4 et des bobines de surtension 5, pour amener les atomes du gaz atomique dans un état énergisé où ils sont aptes à subir la transition atomique lorsqu'ils sont éclairés par le faisceau de lumière, typiquement dans l'état métastable 2³S₁.

Le magnétomètre 20 comprend également un circuit d'excitation de résonances paramétriques qui comporte un générateur de radiofréquence 8 qui alimente des bobines d'Helmholtz 7 d'axes orthogonaux qui entourent la cellule afin de générer un champ magnétique d'excitation des résonances paramétriques, également désigné par champ radiofréquence d'excitation. Ce circuit d'excitation vient plus particulièrement générer un champ magnétique radiofréquence présentant deux composantes orthogonales à la direction de polarisation et oscillant chacune à sa propre fréquence d'oscillation, à savoir une composante B_{ω}cosωt selon l'axe x oscillant à la pulsation ω (avec par exemple ω=2π.3000 kHz) et une composante B_{Ω}cosΩt selon l'axe y oscillant à la pulsation Ω (avec par exemple Ω=2π.16 kHz). Ces composantes conduisent à des résonances à chacune des fréquences d'oscillation Ω/2π, ω/2π et à un inter-harmonique des fréquences d'oscillation (ω ± Ω)/2π, ces résonances étant associées aux valeurs du champ ambiant dans les directions x, y et z respectivement.

Le magnétomètre 20 comprend par ailleurs un photodétecteur 6 agencé pour recevoir le faisceau de lumière ayant traversé la cellule et un circuit de détection de résonances paramétriques 9 configuré pour réaliser une détection synchrone à un harmonique de chacune des fréquences d'oscillation d'un signal électrique délivré par le photodétecteur et une détection synchrone à un inter-harmonique des fréquences d'oscillation du signal électrique délivré par le photodétecteur. Le dispositif 9 comporte trois voies de détection : une première voie Vx pour la détection du signal à Ω /2π (axe x), une second voie Vy pour la détection du signal à ω/2π (axe y), et une troisième voie Vz pour la détection du signal à Ω±ω/2 π (axe z). Le signal sur chacune des première et deuxième voies Vx, Vy est d'abord amplifié puis filtré avec un filtre passe-bande correspondant à la fréquence centrale adéquate (i.e. correspondant à celle du champ RF appliqué). Le signal obtenu est alors multiplié par un signal de référence et traité par un détecteur synchrone DSx, DSy. La troisième voie Vz utilise deux détections synchrones en série, l'une à ω/2π au moyen du détecteur DSy de la deuxième voie Vy et l'autre à Ω /2π au moyen d'un détecteur synchrone DSz.

Le magnétomètre 20 comprend également un circuit d'asservissement 10 du magnétomètre en champ nul. Ce système comprend trois voies d'asservissement Wx, Wy, Wz chacune couplée à une sortie d'une voie de détection correspondante Vx, Vy, Vz. Chacune des voies d'asservissement Wx, Wy, Wz exploite la sortie de la voie de détection correspondante en tant que signal d'erreur pour venir constamment réajuster un champ de compensation. Chacune des voies d'asservissement Wx, Wy, Wz comprend un intégrateur Ix, Iy, Iz configuré pour délivrer un signal de compensation et un générateur de courant GCx, GCy, GCz piloté par le signal de compensation pour injecter du courant dans l'une de trois bobines de Helmholtz 7 et générer un champ magnétique de compensation BCx, BCy, BCz opposé à une composante du champ ambiant Bx, By, Bz. La mesure des courants circulant dans les bobines 7 permet de déduire les champs qu'il est nécessaire d'appliquer pour annuler les différentes composantes du champ ambiant, et donc de disposer de la valeur de ces différentes composantes.

Comme on l'a vu précédemment, le bruit dont est assortie la mesure du champ ambiant selon l'axe z est typiquement au moins un ordre de grandeur plus élevé que celui associés aux deux autres axes, par exemple 4 fois plus grand. Dès lors, le champ magnétique de compensation BCz opposé à la composante Bz du champ magnétique ambiant orientée selon la direction de polarisation est le plus bruité, et est donc le plus susceptible de perturber les mesures réalisées par des magnétomètres agencés à proximité du magnétomètre 20 selon l'invention. Afin de limiter ces perturbations, l'invention propose de configurer le circuit d'asservissement de manière à ce que le champ magnétique de compensation BCz présente une atténuation dans la plage fréquentielle d'intérêt. En réalisant une telle atténuation, l'impact du bruit porté le champ de compensation selon l'axe z est réduit dans la plage d'intérêt sans pour autant altérer la fonction de compensation de la composante du champ magnétique ambiant orientée selon la direction de polarisation, le champ ambiant étant en effet principalement statique.

Une telle atténuation peut être obtenue en dotant le circuit d'asservissement 10 d'un filtre passe bas F_{LP} qui présente une fréquence de coupure sélectionnée pour atténuer le champ magnétique de compensation dans la plage fréquentielle d'intérêt, par exemple une fréquence de coupure sélectionnée pour couper le champ magnétique de compensation au-delà de 0,5 Hz pour une plage fréquentielle d'intérêt comprise entre 1 et 200 Hz.

Le filtre passe-bas peut notamment être agencé sur la voie de compensation Wz après l'intégrateur Iz en étant ainsi interposé entre l'intégrateur Iz et la bobine correspondante du jeu de bobines 7. Comme représenté sur la figure 1, le filtre passe-bas F_{LP} peut notamment être interposé entre l'intégrateur Iz et le générateur de courant GCz. Il peut s'agir d'un filtre numérique agencé en amont d'un convertisseur numérique-analogique disposé par exemple en entrée du générateur de courant, ou encore d'un filtre analogique agencé en aval d'un tel convertisseur numérique-analogique et appliqué sur une tension ou un courant. Le filtre passe-bas peut être un filtre de Butterworth, par exemple d'ordre 4. Avec un filtre de Butterworth d'ordre 4 et de fréquence de coupure 0,5 Hz, le bruit supplémentaire est atténué d'un facteur 16 à 1 Hz et davantage au-delà de cette fréquence dans la plage d'intérêt. Le bruit porté par l'axe z le plus bruité, initialement 4 fois plus grand, devient alors 4/16 soit 4 fois plus faible que le bruit porté par les autres axes x, y. L'axe z peut ainsi être utilisé pour asservir le champ magnétique autour de zéro tout en évitant d'apporter du bruit dans la plage d'intérêt de la mesure réalisée par les autres magnétomètres du réseau.

Selon l'invention, une telle atténuation du champ magnétique de compensation dans la plaque fréquentielle d'intérêt peut également être réalisée pour l'un et/ou l'autre des autres axes de mesure x et y, et ce indépendamment ou non d'une atténuation réalisée sur l'axe z. L'invention s'étend en outre à un dispositif de magnétométrie comprenant un réseau de magnétomètres dont l'un au moins est tel que décrit précédemment. Elle concerne également un procédé d'asservissement en champ nul d'un magnétomètre tel que précédemment décrit, comprenant notamment une étape pouvant être mise en œuvre par ordinateur consistant à contrôler la génération du champ magnétique de compensation de manière à ce qu'il soit atténué dans la plage fréquentielle d'intérêt.

## Revendications

1. Magnétomètre (20) destiné à la mesure d'un champ magnétique ambiant présentant une plage fréquentielle d'intérêt, comprenant :
une source de pompage optique (2, 3) agencée pour émettre en direction d'une cellule (1) remplie d'un gaz atomique un faisceau de lumière polarisé linéairement selon une direction de polarisation,
un circuit d'excitation de résonances paramétriques (7, 8) configuré de manière à induire dans la cellule un champ magnétique radiofréquence présentant deux composantes orthogonales à la direction de polarisation et oscillant chacune à sa propre fréquence d'oscillation,
un circuit de détection de résonances paramétriques (9) configuré pour réaliser une détection synchrone (DSy, DSz) à un inter-harmonique des fréquences d'oscillation d'un signal électrique délivré par un photodétecteur (6) agencé pour recevoir le faisceau de lumière ayant traversé la cellule,
un circuit d'asservissement en champ nul (10) configuré pour générer à partir de ladite détection synchrone un champ magnétique de compensation opposé à une composante du champ magnétique ambiant orientée selon la direction de polarisation,
**caractérisé en ce que** ledit circuit d'asservissement (10) comprend un filtre passe bas (F_{LP}) qui présente une fréquence de coupure sélectionnée pour atténuer le champ magnétique de compensation dans la plage fréquentielle d'intérêt.

2. Magnétomètre selon la revendication 1, dans lequel ledit circuit d'asservissement (10) comprend un intégrateur (Iz) configuré pour délivrer un signal de compensation, un générateur de courant (GCz) apte à être piloté par le signal de compensation pour injecter un courant dans une bobine (7), le filtre passe-bas (F_{LP}) étant interposé entre l'intégrateur et la bobine.

3. Magnétomètre selon la revendication 2, dans lequel le filtre passe-bas est interposé entre l'intégrateur et le générateur de courant.

4. Magnétomètre selon la revendication 3, dans lequel le filtre passe-bas est un filtre numérique.

5. Magnétomètre selon la revendication 4, dans lequel le filtre passe-bas est un filtre de Butterworth d'ordre 4.

6. Dispositif de magnétométrie comprenant un réseau de magnétomètres dont l'un au moins est un magnétomètre (20) selon l'une des revendications 1 à 5.

7. Procédé d'asservissement en champ nul d'un magnétomètre (20) selon la revendication 1 destiné à la mesure d'un champ magnétique ambiant présentant une plage fréquentielle d'intérêt, le procédé comportant une étape consistant à atténuer le champ magnétique de compensation dans la plage fréquentielle d'intérêt au moyen du filtre passe bas (F_{LP}) du circuit d'asservissement (10) dudit magnétomètre (20).

## Patentansprüche

1. Magnetometer (20) für die Messung eines Umgebungsmagnetfelds, das einen Frequenzbereich von Interesse aufweist, umfassend:
Eine optische Pumpquelle (2, 3), die dazu ausgelegt ist, in Richtung einer Zelle (1), die mit einem atomaren Gas gefüllt ist, einen Lichtstrahl zu emittieren, der linear entlang einer Polarisationsrichtung polarisiert ist,
eine Schaltung zur Anregung von parametrischen Resonanzen (7, 8), die dazu konfiguriert ist, in der Zelle ein magnetische Funkfrequenzfeld zu induzieren, das zwei Komponenten aufweist, die orthogonal zur Polarisationsrichtung sind und jeweils bei ihrer eigenen Oszillationsfrequenz oszillieren,
eine Schaltung zur Detektion von parametrischen Resonanzen (9), die dazu konfiguriert ist, eine synchrone Detektion (DSy, DSz) bei einer Zwischenharmonischen der Oszillationsfrequenzen eines elektrischen Signals zu realisieren, das durch einen Photodetektor (6) geliefert wird, der dazu ausgelegt ist, den Lichtstrahl zu empfangen, der die Zelle durchquert hat,
eine Nullfeld-Regelschaltung (10), die dazu konfiguriert ist, ausgehend von der synchronen Detektion ein magnetisches Kompensationsfeld zu generieren, das entgegengesetzt ist zu einer Komponente des Umgebungsmagnetfelds, die entlang der Polarisationsrichtung orientiert ist,
**dadurch gekennzeichnet, dass** die Regelschaltung (10) ein Tiefpassfilter (F_{LP}) umfasst, das eine Abschneidefrequenz aufweist, die dazu ausgewählt ist, das magnetische Kompensationsfeld in dem Frequenzbereich von Interesse abzuschwächen.

2. Magnetometer nach Anspruch 1, bei dem die Regelschaltung (10) einen Integrator (Iz) umfasst, der dazu konfiguriert ist, ein Kompensationssignal zu liefern, einen Stromgenerator (GCz), der dazu ausgelegt ist, durch das Kompensationssignal gesteuert zu werden, um einen Strom in eine Spule (7) zu injizieren, wobei das Tiefpassfilter (F_{LP}) zwischen dem Integrator und der Spule eingefügt ist.

3. Magnetometer nach Anspruch 2, bei dem das Tiefpassfilter zwischen dem Integrator und dem Stromgenerator eingefügt ist.

4. Magnetometer nach Anspruch 3, bei dem das Tiefpassfilter ein digitales Filter ist.

5. Magnetometer nach Anspruch 4, bei dem das Tiefpassfilter ein Butterworth-Filter 4. Ordnung ist.

6. Magnetometrievorrichtung, umfassend ein Netz von Magnetometern, von denen wenigstens eines ein Magnetometer (20) nach einem der Ansprüche 1 bis 5 ist.

7. Verfahren zur Nullfeldregelung eines Magnetometers (20) nach Anspruch 1, das für die Messung eines Umgebungsmagnetfelds ausgelegt ist, das einen Frequenzbereich von Interesse aufweist, wobei das Verfahren einen Schritt umfasst, der darin besteht, das Kompensationsmagnetfeld in dem Frequenzbereich von Interesse mit Hilfe des Tiefpassfilters (F_{LP}) der Regelschaltung (10) des Magnetometers (20) abzuschwächen.

## Claims

1. A magnetometer (20) for the measurement of an ambient magnetic field having a frequency range of interest, comprising:
an optical pumping source (2, 3) arranged to emit, in the direction of a cell (1) filled with an atomic gas, a light beam linearly polarised in a polarisation direction,
a parametric resonance excitation circuit (7, 8) configured so as to induce into the cell a radiofrequency magnetic field having two components orthogonal to the polarisation direction and each oscillating at its own oscillation frequency,
a parametric resonance detection circuit (9) configured to perform synchronous detection (DSy, DSz) at an inter-harmonic of the oscillation frequencies of an electrical signal output by a photodetector (6) arranged to receive the light beam having passed through the cell,
a zero-field feedback control circuit (10) configured to generate from said synchronous detection a compensation magnetic field opposite to a component of the ambient magnetic field oriented in the polarisation direction,
**characterized in that** said feedback control circuit (10) comprises a low-pass filter (F_{LP}) which has a cut-off frequency selected to attenuate the compensation magnetic field within the frequency range of interest.

2. A magnetometer according to claim 1, in which said feedback control circuit (10) comprises an integrator (Iz) configured to output a compensation signal, a current generator (GCz) capable of being piloted by the compensation signal to inject current into a coil (7), the low-pass filter (F_{LP}) being interposed between the integrator and the coil.

3. A magnetometer according to claim 2, in which the low-pass filter is interposed between the integrator and the current generator.

4. A magnetometer according to claim 3, in which the low-pass filter is a digital filter.

5. A magnetometer according to claim 4, in which the low-pass filter is a 4-order Butterworth filter.

6. A magnetometry device comprising a network of magnetometers, at least one of which is a magnetometer (20) according to one of claims 1 to 5.

7. A method of zero-field feedback control of a magnetometer (20) according to claim 1, for the measurement of an ambient magnetic field having a frequency range of interest, the method comprising a step consisting of attenuating the compensation magnetic field in the frequency range of interest by means of the low-pass filter (F_{LP}) of the feedback control circuit (10) of said magnetometer (20).
